# EUROPÄISCHE PATENTSCHRIFT

(11) **EP 2 327 668 B1**
(45) Veröffentlichungstag und Bekanntmachung des Hinweises auf die Patenterteilung: **04.05.2016**
(21) Anmeldenummer: 10191297.0
(22) Anmeldetag: 16.11.2010
(51) Int. Cl.: C03C 17/34, C08J 7/04, C23C 14/04, C23C 28/00, H01L 27/142, H01L 31/00, H01L 31/0216, H01L 31/032, H01L 31/0336, H01L 31/0392

(54) **BESCHICHTUNG MIT ZELLSTRUKTUR**
COATING WITH CELLULAR STRUCTURE
REVÊTEMENT DOTÉ D'UNE STRUCTURE DE CELLULE

(30) Priorität: 26.11.2009 DE 102009055992
(43) Veröffentlichungstag der Anmeldung: 01.06.2011
(73) Patentinhaber: Robert Bosch GmbH, 70442 Stuttgart (DE)
(72) Erfinder: Ramsteiner, Ingo, 71229, Leonberg (DE)

(56) Entgegenhaltungen:
- WO-A1-98/58885
- WO-A1-03/093185
- US-A1- 2007 215 204
- US-A1- 2009 084 425

## Beschreibung

Die Erfindung betrifft eine Beschichtung gemäß Anspruch 1.

In der Architektur oder dem Automobilbau werden Oberflächen häufig mit einer Beschichtung veredelt. Dabei kommen unterschiedliche und vom Verwendungszweck abhängige Beschichtungen zum Einsatz. Beispielsweise wird der Wärmedurchgangskoeffizient (µ-Wert) von Verglasungen durch den Einsatz niedrigemittierender Beschichtungen, sogenannter low-e Beschichtungen, deutlich gesenkt. Diese Beschichtungen sind häufig auf einer Metalloxid-Basis aufgebaut, wobei vor allem sogenannte TCO's (transparente leitfähige Oxide) verwendet werden. Diese OxidSchichten werden meist durch physikalische oder chemische Gasphasenabscheidung erzeugt.

Viele solcher zur Veredelung verwendeten Funktionsschichten sind empfindlich gegenüber mechanischer Belastung, Witterungseinflüssen, Säureeinwirkung o. dgl. und müssen daher für eine langlebige Anwendung mit einer Schutzschicht versehen werden. Diese Schutzschicht schützt dann die unter ihr liegende Funktionsschicht vor den oben genannten Einflüssen. Die üblichen Beschichtungen überziehen die Funktionsschicht nahezu vollflächig und bilden so eine Schutzschicht aus.

Punktuelle Schäden in der Schutzschicht, wie sie beispielsweise durch starke mechanische Belastung oder durch Fertigungsfehler entstehen können, exponieren die darunter liegende empfindliche Funktionsschicht hinsichtlich äußerer Einflüsse. Dies hat den Nachteil, dass sich selbst kleinere Schäden in der Funktionsschicht nach ihrer Entstehung immer weiter ausbreiten können. Die Auswirkungen sind umso größer, je empfindlicher die Funktionsschicht ist.

Die Funktionsschichten aus Oxiden werden aber auch in hochsensiblen Umgebungen eingesetzt, z. B. in der Beleuchtungstechnik, in der Automobiltechnik und der Architekturverglasung finden sie Verwendung. Aus diesem Grund können insbesondere in diesen Bereichen viele kostengünstige Materialien für die Ausbildung der Funktionsschicht nachteiligerweise nicht eingesetzt werden.

Aufgabe der vorliegenden Erfindung ist es daher, diesen und weitere Nachteile im Stand der Technik zu überwinden, und eine Beschichtung zur Verfügung zu stellen, die neben dem bekannten Basisschutz für empfindliche Funktionsschichten durch eine Schutzschicht, ein weiteres Mittel vorsieht, dass die Ausbreitung entstandener Schäden lokal begrenzt. Die Beschichtung soll ferner kostengünstig und mit einfachen Mitteln herstellbar sein.

Die Erfindung wird durch die in den Ansprüchen gekennzeichneten Ausführungsformen gelöst. Gemäss der vorliegenden Anmeldung wird ein Fassadenelement, eine Glassscheibe bzw. ein thermischer oder photovoltaischer Solarkollektor mit einer Beschichtung bereitgestellt.

Bei einer Beschichtung, welche auf einen Träger aufgebracht ist, zur Erzeugung eines flächigen Gegenstandes mit einer Oberflächenbeschichtung, ausgewählt aus der Gruppe umfassend ein Fassadenelement, eine Glasscheibe mit einer Oberflächenbeschichtung, ein thermischer oder photovoltaischer Solarkollektor mit einer Abdeckscheibe mit einer Oberflächenbeschichtung, umfassend wenigstens eine Funktionsschicht und eine Schutzschicht, wobei die Schutzschicht die Funktionsschicht schützt und aus SiOₓN_{y} besteht, sieht die Erfindung vor, dass die Funktionsschicht eine Oxidschicht aus einem transparenten, leitfähigen Oxid ist und eine Zellstruktur aufweist, die aus einzelnen Zellen (21) aufgebaut ist, wobei die Zellen (21) quadratisch, rechteckig, dreieckig, parallelogramm-, rauten-, waben- oder kreisförmig sind oder aus der Mathematik bekannte Formen für eine Penrose-Parkettierung besitzen und wobei zwischen den Zellen (21) Zellzwischenräume (13) vorgesehen sind, in denen ein Barrieremedium (14) ist, welches die chemische Zusammensetzung der Schutzschicht (12) aufweist.

Die Zellstruktur bietet ein einfaches und wirkungsvolles Mittel, durch welches die Ausbreitung entstandener Schäden innerhalb der Funktionsschicht vermieden wird. Meist entstehen diese Schäden, durch eine vorangehende Beschädigung der zugehörigen Schutzschicht oder durch Fertigungsfehler. Eine Beschädigung der Schutzschicht durch mechanische Belastung, z.B. bei Montage oder Transport, kann meist nicht verhindert werden. Die erfindungsgemäße Beschichtung reduziert so die Ausschussquote bei der Herstellung der beschichteten Träger, da auch Teile mit kleinen Fehlern weiterverwendet werden können. Die Lebensdauer der Beschichtung bzw. eines durch die Beschichtung veredelten Trägers erhöht sich zudem signifikant. Die lokale Begrenzung des Defekts innerhalb der Funktionsschicht ermöglicht auch einen Einsatz der Beschichtung unter vergleichsweise harschen Bedingungen.

Je nach Anwendung kann es sinnvoll sein mehrere Funktionsschichten und/oder Schutzschichten zu verwenden. Des Weiteren können neben den genannten Schichten auch zusätzliche Schichten wie Trennschichten o. dgl. vorgesehen sein. Bei Verglasungen ist beispielsweise der Einsatz sogenannter low-e-Beschichtungen in Kombination mit photokatalytischen TiO₂-Schichten denkbar. Die photokatalytischen TiO₂-Schichten können die Bewitterungsverschmutzung von Außenoberflächen erheblich verringern.

Das Barrieremedium kann auch aus mehreren Bestandteilen aufgebaut sein. Denkbar ist beispielsweise eine Zusammensetzung aus verschiedenen, bevorzugt festen, Materialien, welche in die Zellzwischenräume eingebracht sind, oder eine Kombination aus Luft mit einem oder mehreren zum Schutz geeigneten Materialien.

Die erfindungsgemäße Zellstruktur bietet vielfältige Variationsmöglichkeiten mit deren Hilfe die Beschichtung gezielt auf die jeweilige Anwendung abgestimmt werden kann. Entscheidende Kriterien hierbei sind unter anderem die angestrebte Lebensdauer, der Fertigungsaufwand, das Anwendungsgebiet sowie ästhetische Beweggründe. Grundsätzlich gilt: Je breiter die Zellzwischenräume, desto größer ist die Schutzwirkung, aber desto kleiner ist auch der Bedeckungsgrad des Trägers mit der Funktionsschicht.

Besonders vorteilhaft sind die Zellen wabenförmig, quadratisch, dreieckig, rechteckig oder kreisförmig. Dadurch sind auch Beschichtungen auf Gegenständen, die komplizierte Geometrien aufweisen, mit der erfindungsgemäßen Zellstruktur ausbildbar.

Besonders vorteilhaft sind hexagonale Waben, Rechtecke, Quadrate oder Parallelogramme, weil sie eine periodische Parkettierung der beschichteten Fläche ermöglichen. Das gleiche gilt für komplexere Formen, wie sie von Beton-Pflastersteinen her bekannt sind. Aperiodische Parkettierungen (sog. Penrose-Muster) sind mit den in der Mathematik wohlbekannten Penrose-Kachel-Formen möglich. Unter einer Parkettierung im mathematischen Sinne versteht man die lückenlose und überlappungsfreie Bedeckung einer Ebene durch die einzelnen Flächenelemente. Setzt man solche Formen mit einem gewissen Abstand zueinander ein, so lässt sich hierdurch an allen Stellen des Musters eine einheitliche Barrierebreite realisieren, zum Beispiel die für die Schadensbegrenzung minimal erforderliche Breite. Das hat den Vorteil, dass den Barrieren nicht mehr Fläche geopfert wird, als für ihre Funktion unbedingt nötig. Bei gegebener Zellgröße wird der durch die Funktionsschicht bedeckte Flächenanteil also maximiert.

Die Erfindung sieht vor, dass die Funktionsschicht eine Oxidschicht ist, welche aus einem transparenten, leitfähigen Oxid besteht. Hierbei kann es sich um Indiumoxid, Zinnoxid oder Zinkoxid oder um undotierte oder mit verschiedenen Substanzen dotierte Oxide handeln. Für den Einsatz einer Beschichtung unter Witterungseinfluss eignen sich unter anderem insbesondere Schutzschichten, welche aus SiOₓN_{y} bestehen.

Die Funktionsschicht ist bevorzugt eine Schicht, welche durch physikalische oder chemische Gasphasenabscheidung hergestellt ist. Die Zellstruktur der Funktionsschicht ist durch den Einsatz einer Maske beim Beschichtungsprozess, oder das gezielte Abtragen von Teilen der Funktionsschicht nach dem Beschichten mit Hilfe eines Lasers oder einem mechanischen Verfahren, oder durch ein Lithographieverfahren erzeugbar. So kann die Zellstruktur ohne großen technischen Aufwand in den herkömmlichen Herstellungsprozess eingebunden werden. Dies führt zu einer kostengünstigen Herstellung. Darüber hinaus können aber auch verschiedene andere Techniken zur Erzeugung der Beschichtung angewendet werden.

Der Träger, auf welchem die Beschichtung aufgebracht werden kann, kann ein Glas, ein glasiertes Material, ein Kunststoff, eine Keramik oder ein Metall sein. Diese Materialien sind glatt und weisen eine hohe Dichte auf. Die Funktionsschicht kann somit nicht durch den Träger hindurch diffundieren.

Durch das Aufbringen einer erfindungsgemäßen Beschichtung auf einen Träger wird ein flächiger Gegenstand mit einer Oberflächenbeschichtung erzeugt. Ein solcher Gegenstand ist ein Fassadenelement, oder eine Glasscheibe mit einer Oberflächenbeschichtung oder ein thermischer oder photovoltaischer Solarkollektor mit einer Abdeckscheibe mit einer Oberflächenbeschichtung.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Darstellung einer auf einen Träger aufgebrachten Beschichtung mit einer beschädigten Zelle;
- Fig. 2: eine erfindungsgemäße Zellstruktur einer Funktionsschicht.

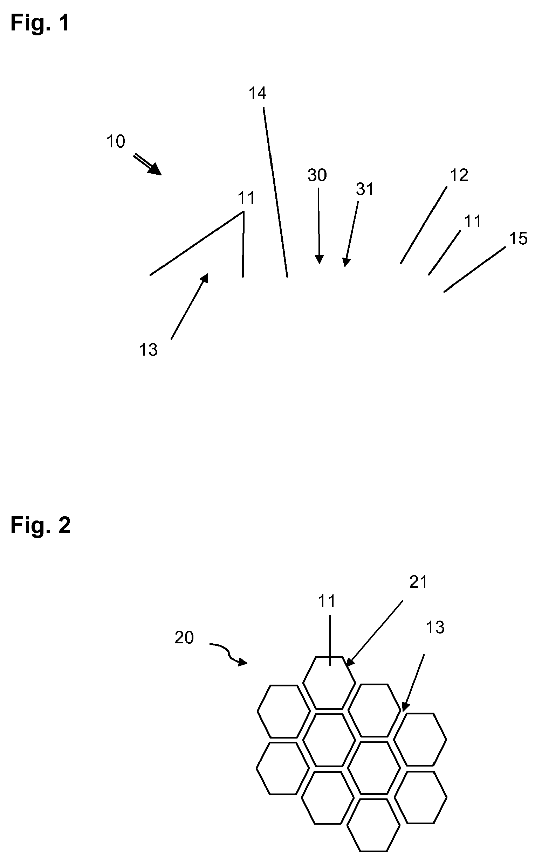

Figur 1 zeigt schematisch einen Träger 15, auf dem eine erfindungsgemäße Beschichtung 10 aufgebracht ist. Hier sind eine beschädigte Zelle 31 und drei intakte Zellen 21 erkennbar.

Der Träger 15 kann beispielsweise ein Glas, eine Keramik, ein Kunststoff oder ein Metall sein. Die dargestellte Beschichtung 10 umfasst eine Funktionsschicht 11 und eine Schutzschicht 12. Die Funktionsschicht 11 ist in Form von Zellen 21 auf den Träger 15 aufgebracht. Zwischen den Zellen 21 sind Zellzwischenräume 13 in denen sich das Barrieremedium 14 befindet. In der dargestellten Ausführungsform sind die Zellen 21 der Funktionsschicht 11 mit der Schutzschicht 12 überzogen, wobei das Barrieremedium 14 die chemische Zusammensetzung der Schutzschicht 12 aufweist.

Vorteilhaft bei einer derartigen Ausgestaltung ist, dass das Barrieremedium 14 und die Schutzschicht 12 im gleichen Arbeitschritt aufgetragen werden können. Durch das Barrieremedium 14 kann sich die Beschädigung 30 nur innerhalb dieser beschädigten Zelle 31 und nicht darüber hinaus ausbreiten. Dadurch wird eine effektive lokale Begrenzung des Schadens erreicht.

Figur 2 zeigt eine erfindungsgemäße Zellstruktur 20 einer Funktionsschicht 11. In der dargestellten Ausführungsform sind Zellen 21 als sechskantige Waben ausgebildet. Zwischen den Zellen 21 sind Zellzwischenräume 13 vorgesehen. Die räumliche Trennung der Zellen 21 durch die Zellzwischenräume 13 verhindert eine Schadensausbreitung innerhalb der Funktionsschicht 11 über eine Zelle 21 hinaus.

## Patentansprüche

1. Beschichtung (10), welche auf einen Träger (15) aufgebracht ist, zur Erzeugung eines flächigen Gegenstandes mit einer Oberflächenbeschichtung, ausgewählt aus der Gruppe umfassend ein Fassadenelement, eine Glasscheibe mit einer Oberflächenbeschichtung, ein thermischer oder photovoltaischer Solarkollektor mit einer Abdeckscheibe mit einer Oberflächenbeschichtung, umfassend wenigstens eine Funktionsschicht (11) und eine Schutzschicht (12), wobei die Schutzschicht (12) die Funktionsschicht (11) schützt und aus SiOₓN_{y} besteht, **dadurch gekennzeichnet, dass** die Funktionsschicht (11) eine Oxidschicht aus einem transparenten, leitfähigen Oxid ist und eine Zellstruktur (20) aufweist, die aus einzelnen Zellen (21) aufgebaut ist, wobei die Zellen (21) quadratisch, rechteckig, dreieckig, parallelogramm-, rauten-, waben- oder kreisförmig sind oder aus der Mathematik bekannte Formen für eine Penrose-Parkettierung besitzen und wobei zwischen den Zellen (21) Zellzwischenräume (13) vorgesehen sind, in denen ein Barrieremedium (14) ist, welches die chemische Zusammensetzung der Schutzschicht (12) aufweist.

2. Beschichtung (10) nach Anspruch 1, **dadurch gekennzeichnet, dass** die Funktionsschicht aus Indiumoxid oder Zinnoxid oder Zinkoxid besteht.

3. Beschichtung (10) nach einem der vorhergehenden Ansprüche, **dadurch gekennzeichnet, dass** die Funktionsschicht (11) durch physikalische oder chemische Gasphasenabscheidung herstellbar ist.

4. Beschichtung (10) nach einem der vorhergehenden Ansprüche, **dadurch gekennzeichnet, dass** die Zellstruktur (20) der Funktionsschicht (11) durch Einsatz einer Maske beim Beschichtungsprozess, durch gezieltes Abtragen nach dem Beschichten mit Hilfe eines Lasers oder mechanisch, oder durch ein Lithographieverfahren erzeugbar ist.

5. Beschichtung (10) nach einem der vorhergehenden Ansprüche, **dadurch gekennzeichnet, dass** der Träger (15) ein Glas, oder ein glasiertes Material oder ein Kunststoff oder eine Keramik oder ein Metall ist.

## Claims

1. Coating (10) which is applied to a substrate (15) for generating a sheet-like object with a surface coating, selected from the group comprising a façade element, a glass pane with a surface coating, a thermal or photovoltaic solar collector with a covering pane with a surface coating, comprising at least one functional layer (11) and a protective layer (12), wherein the protective layer (12) protects the functional layer (11) and consists of SiOₓN_{y}, **characterized in that** the functional layer (11) is an oxide layer of a transparent, conductive oxide and has a cellular structure (20) which is built up from individual cells (21), wherein the cells (21) are square, rectangular, triangular, parallelogram-shaped, rhombus-shaped, honeycomb-shaped or circular or have Penrose parquetting shapes known from mathematics and wherein, between the cells (21), there are provided cell interstices (13) in which there is a barrier medium (14) which has the chemical composition of the protective layer (12).

2. Coating (10) according to Claim 1, **characterized in that** the functional layer consists of indium oxide or tin oxide or zinc oxide.

3. Coating (10) according to either of the preceding claims, **characterized in that** the functional layer (11) can be produced by physical or chemical vapour deposition.

4. Coating (10) according to one of the preceding claims, **characterized in that** the cellular structure (20) of the functional layer (11) can be generated by the use of a mask during the coating process, by targeted ablation after coating with the aid of a laser or mechanically, or by a lithographic process.

5. Coating (10) according to one of the preceding claims, **characterized in that** the substrate (15) is a glass or a glazed material or a plastic or a ceramic or a metal.

## Revendications

1. Revêtement (10) appliqué sur un support (15) en vue de former un objet plat doté d'un revêtement de surface,
l'objet plat étant sélectionné dans l'ensemble comprenant un élément de façade, une vitre dotée d'un revêtement de surface, un collecteur solaire thermique ou photovoltaïque doté d'une vitre de recouvrement munie d'un revêtement de surface et
comprenant au moins une couche fonctionnelle (11) et une couche de protection (12),
la couche de protection (12) protégeant la couche fonctionnelle (11) et étant constituée de SiOₓN_{y}, **caractérisé en ce que**
la couche fonctionnelle (11) est une couche d'oxyde constituée d'un oxyde conducteur transparent et présente une structure cellulaire (20) constituée de cellules (21) distinctes, les cellules (21) ayant la forme d'un carré, d'un rectangle, d'un triangle, d'un parallélogramme, d'un losange, d'un nid d'abeilles ou d'un cercle ou possédant des formes mathématiquement connues permettant un recouvrement de Penrose et
**en ce que** des espaces intermédiaires (13) qui présentent un agent de barrière (14) dont la composition chimique est celle de la couche de protection (12) sont prévus entre les cellules (21).

2. Revêtement (10) selon la revendication 1, **caractérisé en ce que** la couche fonctionnelle est constituée d'oxyde d'indium, d'oxyde d'étain ou d'oxyde de zinc.

3. Revêtement (10) selon l'une des revendications précédentes, **caractérisé en ce que** la couche fonctionnelle (11) peut être réalisée par dépôt physique ou chimique en phase vapeur.

4. Revêtement (10) selon l'une des revendications précédentes, **caractérisé en ce que** la structure cellulaire (20) de la couche fonctionnelle (11) peut être formée en recourant à un masque lors de l'opération de revêtement, par enlèvement contrôlé après le revêtement, à l'aide d'un laser, mécaniquement ou par une opération de lithographie.

5. Revêtement (10) selon l'une des revendications précédentes, **caractérisé en ce que** le support (15) est un verre, un matériau vitrifié, une matière synthétique, une céramique ou un métal.
